# EUROPEAN PATENT SPECIFICATION

(11) **EP 2 123 800 B1**
(45) Date of publication and mention of the grant of the patent: **07.03.2012**
(21) Application number: 09006706.7
(22) Date of filing: 19.05.2009
(51) Int. Cl.: C30B 15/10, C30B 35/00

(54) **Crucible holding member and method for producing the same**
Tiegelhalterungselement und Herstellungsverfahren dafür
Élément support de creuset et son procédé de fabrication

(30) Priority: 21.05.2008 JP 2008133336
(43) Date of publication of application: 25.11.2009
(73) Proprietor: Ibiden Co., Ltd., Ogaki-shi, Gifu 503-8604 (JP)
(72) Inventor: Kato, Hideki, Ogaki, Gifu (JP); Shikano, Haruhide, Ogaki, Gifu (JP); Yasuda, Masahiro, Ogaki, Gifu (JP)
(74) Representative: HOFFMANN EITLE

(56) References cited:
- WO-A-02/059061
- FR-A- 2 753 993
- JP-A- 2002 154 893

## Description

### BACKGROUND OF THE INVENTION

### Field of the Invention

The present invention relates to a crucible holding member for holding a crucible for containing a high-temperature melt such as metal, glass or silicon and a method for producing the same, and particularly to a crucible holding member for holding a quartz crucible used in a silicon single crystal pulling-up operation and a method for producing the same.

### Description of the Related Art

A carbon material has heretofore been widely used in a silicon single crystal pulling apparatus, for the reasons that the carbon material has high heat resistance and high thermal shock properties, and that the carbon material hardly contaminates silicon. In particular, an isotropic graphite material is hard to react with a reactive gas such as SiO generated in the apparatus due to its high density, and the reaction rate of the isotropic graphite material with SiO₂ as a material for a quartz crucible for containing a silicon melt is small. Accordingly, the isotropic graphite material has been used as a graphite crucible for holding the periphery of the quartz crucible.

In recent years, an increase in diameter of a silicon wafer has progressed in order to increase yield and improve productivity, and a 300-mm wafer has been becoming mainstream. The development of a wafer further increased in diameter exceeding 400 mm has also been advanced. With this increase in diameter of the silicon wafer, the size of the silicon single crystal pulling apparatus becomes large, so that the weight of the graphite crucible used in the pulling apparatus becomes extremely heavy, resulting in the difficulty of handling such as setting of the graphite crucible to the apparatus.

Further, a production process of the isotropic graphite material requires a press process under hydrostatic pressure, and requires a Cold Isostatic Press (CIP) apparatus having a size of about 1.5 times the diameter of the graphite product. The diameter of the conventional CIP apparatus is not enough for the isotropic graphite material as a large-size graphite crucible, so that a larger apparatus becomes necessary.

As a technique for producing the large-size graphite crucible without using the CIP apparatus, there has been proposed a technique including forming carbon fibers into a crucible form by a filament winding process, impregnating it with a resin or pitch as a matrix, and burning it to produce a crucible made of a carbon/carbon fiber composite, hereinafter referred to as a C/C composite (for example, see JP-A-10-152391 or JP-A-11-60373), and a technique including adhering carbon fiber cloth to a forming die, performing molding and curing to obtain a carbon fiber-reinforced plastic, and then, impregnating and burning it to produce a crucible made of a C/C composite (for example, see JP-A-10-243275), or the like.

In the meantime, in the silicon single crystal pulling-up apparatus, a single crystal ingot is produced while melting silicon, so that it is necessary to heat the inside of the apparatus to a temperature equal to or higher than the melting point (1,420°C) of silicon. When silicon is melted, the graphite crucible and the quartz crucible inserted therein are softened to adhere to each other.

The coefficient of thermal expansion of quartz glass is 0.6x10⁻⁶/°C, and that of the C/C composite is generally equivalent thereto. Accordingly, when the apparatus is cooled after the silicon melt has been almost removed after completion of pulling-up of the single crystal ingot, both are cooled without being strongly restricted with each other.

However, when the silicon melt coagulates by a trouble such as a power failure immediately after the pulling-up is initiated, silicon has the property of expanding (a volume expansion of about 9.6%) with coagulation. Accordingly, this acts as the function of enlarging the quartz crucible and the graphite crucible.

In the case of the apparatus for pulling up a small-diameter single crystal ingot, even when such a trouble occurs, cooling is performed for a short period of time, and moreover, the amount of the non-coagulated melt leaked out is small. However, in the case of the apparatus for pulling up a large-diameter single crystal ingot, when such a trouble occurs, it takes time for cooling, and once the melt starts to be leaked out, a large amount of the melt flows out to a bottom portion of the apparatus, which causes significant damage.

The crucible made of the C/C composite prepared by using the filament winding process as described in the above-mentioned publication JP-A-10-152391 or JP-A-11-60373 has extremely high strength because of existence of a large number of carbon fibers wound in a direction parallel to a circumferential direction thereof, so that this crucible is suitable for a large-size graphite crucible. However, when the above-described trouble occurs, the silicon melt expands at the time of its coagulation. Accordingly, this acts as the function of breaking the carbon fibers aligned in the circumferential direction, so that a crack in the crucible made of the C/C composite due to the breakage of the carbon fibers may occur.

Further, also in the crucible prepared by adhering the carbon fiber cloth as described in the above-mentioned publication JP-A-10-245275, a large number of carbon fibers aligned in the circumferential direction exist. Accordingly, a crack in the crucible made of the C/C composite due to tension applied in the circumferential direction may occur similarly to the above.

Furthermore, in a production process of the crucible made of the C/C composite described in the above-mentioned publications, the carbon fibers are wound on or the carbon fiber cloth is adhered to the forming die to forming a shape, a matrix precursor such as a resin is impregnated in the carbon fibers or the carbon fiber cloth, and heat curing and burning carbonization are performed together with the forming die, followed by releasing from the forming die. In these steps, strong tension is also applied to the carbon fibers due to the difference in the thermal expansion coefficient between the forming die and the crucible made of the C/C composite, which may cause the breakage of the carbon fibers.

Such disadvantages are not limited to the graphite crucible for the silicon single crystal pulling-up apparatus, but similar problems occur in the above-mentioned various fields in which a container contains another container different therefrom in the coefficient of thermal expansion in the inside thereof. It has therefore been desired to develop a crucible holding member having sufficient strength to support a container having heavy weight and suppressing occurrence of cracks and the like even when tension occurs in the circumferential direction.
In addition, although the C/C composite is a material having excellent strength, it is woven with strands each comprising the plurality of carbon fibers. Accordingly, the contact between the strands and the quartz crucible becomes line contact to cause the occurrence of spaces. It is therefore difficult to secure a large contact area (poor in adhesion), so that it has been desired to develop a crucible holding member having better thermal conductivity.
WO 02/059061 A1 relates to a method for making a carbon/carbon crucible holder, in particular for receiving silica crucibles in the silicon industry. The crucible is woven from at least a 2.5D fabric which is impregnated with a resin and is first carbonised and then has vapour phase carbon deposited to it.
FR 2753993 A1 discloses a 2.5D fabric such as might be employed in the method of WO 02/059061 A1.
JP 2002/154893 A discloses a method of manufacturing a carbon/carbon composite crucible holding member in which the inner surface of the carbon/carbon composite crucible holding member is coated with a carbonaceous layer comprising carbonaceous fine powder and a firm setting resin.

### SUMMARY OF THE INVENTION

An advantage obtainable with embodiments of the present invention is to provide a crucible holding member which is stable in shape even when strong tension acts in the circumferential direction, while securing sufficient strength, and moreover, has good thermal conductivity, and a method for producing the same.
(1) According to an aspect of the present invention, there is provided a crucible holding member as recited in Claim 1 below.
   According to this configuration, the strands are diagonally woven, so that it is stable in shape even when strong tension acts in the circumferential direction. The carbonaceous layer formed on the inner circumferential surface fills the spaces between the crucible and the mesh body to increase the contact area between the crucible and the mesh body.
   According to this configuration, rigidity in the circumferential direction is low, so that even when such force that expands in the circumferential direction acts on the crucible holding member, the mesh body can be enlarged in the circumferential direction by distortion of rhomboid-shaped lattices formed by the first strands and the second strand, thereby being able to absorb expansion in the circumferential direction.
(2) In the crucible holding member of (1), the carbonaceous layer may be formed by mixing a carbon aggregate into a resin material as a carbon precursor.
   According to this configuration, a paste in which the carbon aggregate is kneaded with the resin material acting as the carbon precursor is applied onto the inner circumferential surface, and burned, whereby the carbonaceous aggregate acts as a reinforcing material in which it is integrally embedded in resinous coal to increase not only the strength of the carbonaceous layer, but also the strength of the whole crucible holding member.
(3) In the crucible holding member of (2), the carbonaceous layer may comprise, as carbon aggregate, any one of natural graphite powder, artificial graphite powder, coke and carbon short fibers.
   According to this configuration, an easily crystallizable carbonaceous material such as coke or graphite is used as carbon aggregate, thereby being able to remove impurities present in the carbonaceous layer by a purifying gas while sufficiently securing the strength of the carbonaceous layer.
(5) In the crucible holding member above, the mesh body may comprise a plurality of longitudinal strands aligned substantially along the axis line of the mesh body.
   According to this configuration, the load of the crucible acting in a vertical direction agrees with an extending direction of the longitudinal strands, so that the withstand load in the vertical direction of the mesh body (that is, the strength for carrying the crucible) increases.
(6) In the crucible holding member of any one of (1) to (5), the mesh body may be free from strands aligned in a direction substantially perpendicular to the axis line of the mesh body.
   According to this configuration, even when such force as to expand in the circumferential direction acts, stress is not concentrated to some of the strands, because there is present no strand in the circumferential direction, resulting in no occurrence of breakage of the strands.
(8) According to another aspect of the present invention, there is provided a method for producing a crucible holding member as recited in Claim 4 below.
   According to this configuration, the resin material acting as the carbon precursor is applied onto the inner circumferential surface of the mesh body formed by diagonally weaving the strands comprising the carbon fibers, followed by curing, thereby obtaining the carbonaceous layer as a coating layer having good thermal conductivity for filling the spaces between the crucible and the mesh body.
(10) In the method of (8), the weaving may comprise providing a plurality of longitudinal strands aligned substantially along the axis line of the mesh body.
   According to the above configuration, the crucible holding member comprises the mesh body woven by diagonally aligning the strands comprising the carbon fibers, the matrix filled in the interstices between the carbon fibers and the carbonaceous layer formed on the inner circumferential surface of the mesh body in close contact with the outer circumferential surface of the crucible, and there is no breakage of the carbon fibers by after treatment. Accordingly, the shape thereof is stable while securing sufficient strength, even when strong tension is applied in the circumferential direction thereof, and moreover, the spaces between the crucible holding member and the crucible are eliminated to increase the contact area, thereby being able to improve thermal conductivity.

According to the above method, the mesh body is formed by diagonally weaving the strands comprising the carbon fibers, the matrix is filled in the interstices between the carbon fibers of the mesh body, and the coating layer comprising pyrolytic carbon is formed on the inner circumferential surface of the mesh body. Accordingly, the carbonaceous layer having sufficient thermal conductivity for filling the spaces between the crucible holding member and the crucible can be easily formed as a flat coating surface on the inner circumferential surface of the mesh body woven by diagonally aligning the strands comprising the carbon fibers.

### BRIEF DESCRIPTION OF THE DRAWINGS

The above and other aspects of the present invention will become more apparent and more readily appreciated from the following description of exemplary embodiments of the present invention taken in conjunction with the attached drawings, in which:

Fig. 1 is a perspective view showing a mesh body of a crucible holding member according to the invention;

Fig. 2 is an enlarged front view showing a part of the mesh body shown in Fig. 1;

Fig. 3 is an enlarged cross-sectional view schematically showing a part of a plane including an axis line of the crucible holding member shown in Fig. 1;

Fig. 4 is a flow chart showing a procedure of a production method of a crucible holding member;

Fig. 5 is a schematic view showing a procedure of a production method of a crucible holding member;

Fig. 6 is a cross-sectional view showing a silicon single crystal pulling-up apparatus using the crucible holding member according to the embodiment;

Fig. 7 is an enlarged front view showing a part of a modified example of a weave configuration having no longitudinal strands;

Fig. 8 is an enlarged front view showing a part of a modified example of a weave configuration having a plurality of diagonal strands; and

Fig. 9 is a schematic view showing one example of obtaining a carbonaceous layer by kneading (mixing) an aggregate with a resin material as a carbon precursor.

### DETAILED DESCRIPTION

Embodiments of crucible holding members according to the present invention will be described in detail with reference to the accompanying drawings.

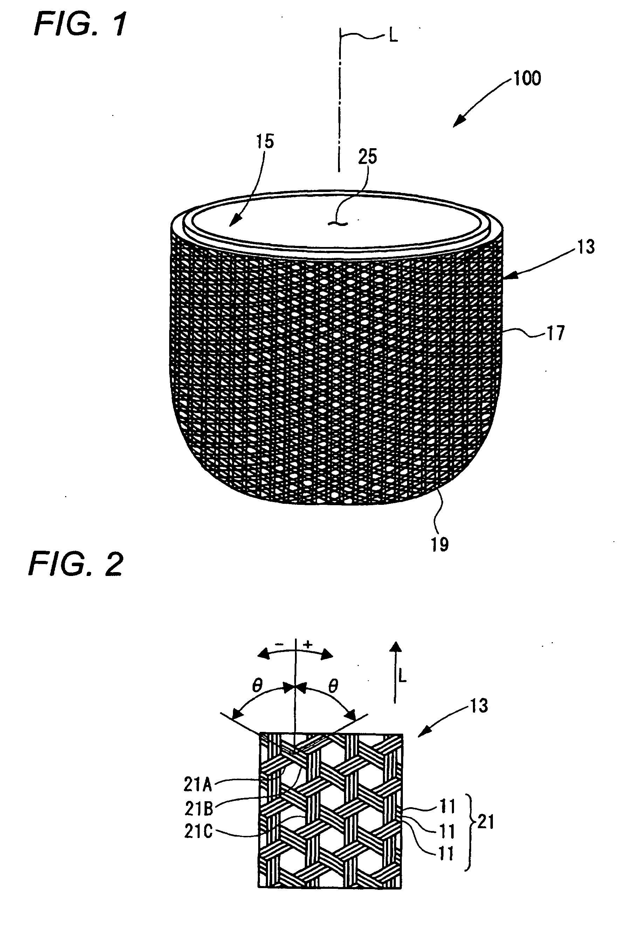

Fig. 1 is a perspective view showing a mesh body of a crucible holding member according to an embodiment of the invention, and Fig. 2 is an enlarged front view showing a part of the mesh body shown in Fig. 1.

The crucible holding member 100 according to this embodiment comprises a mesh body 13 formed of carbon fibers 11, a matrix filled in the interstices between the carbon fibers 11 of the mesh body 13 and a carbonaceous layer 15 formed on an inner circumferential surface of the mesh body 13.

The mesh body 13 has a substantially basket-like form having a closed end at bottom. Specifically, the mesh body 13 comprises a substantially cylindrical body portion 17 and a bowl-shaped bottom portion 19. This mesh body 13 is formed by triaxial weaving, using ribbon-like strands 21 each obtained by bundling a plurality of carbon fibers 11 as plaited threads. That is, the mesh body 13 has a triaxial weave structure comprising first strands 21A aligned at an angle of inclination of (0<θ<90) (first angle) with respect to an axis line L of the mesh body 13, second strands 21B aligned at an angle of inclination of -θ (second angle), and longitudinal strands 21C aligned substantially parallel to (along) the axis line L.

This mesh body 13 can secure high strength because the first strands 21 A and the second strands 21B are braided with each other in a braid form, and can firmly hold a crucible. Moreover, the first strands 21A and the second strands 21B are aligned diagonally to the axis line L of the mesh body 13, and not aligned in a direction perpendicular to the central axis (that is, in the circumferential direction of the mesh body 13), so that there is obtained a structure in which the rigidity in the circumferential direction is low. For this reason, even when such force that expands in the circumferential direction acts on the crucible holding member 100 due to a cause of some kind, rhomboid-shaped lattices formed by the first strands 21A and the second strands 21B are distorted, whereby the mesh body 13 can be enlarged in the circumferential direction to be capable of absorbing expansion in the circumferential direction. Accordingly, the breakage of the carbon fibers is not likely to occur, and the shape is not largely lost, so that the crucible holding member is excellent in shape stability.

Further, in the mesh body 13, the angle of inclination θ of the first strands 21A and the second strands 21B with respect to the axis line L can be appropriately changed, depending on the rigidity required for each part of the crucible holding member 100. The rigidity in the circumferential direction of the mesh body 13 can be adjusted by changing the angle of inclination θ, so that the rigidity in the circumferential direction can be changed depending on the usage or according to each part of the mesh body 13. In other words, the first and second angles vary according to a part (position) of the mesh body 13.

The mesh body 13 has the longitudinal strands 21C aligned in the direction parallel to the axis line L (woven in the same plane as the axis line L). Since the mesh body has the longitudinal strands 21C, the load of the crucible acting in a vertical direction agrees with an extending direction of the longitudinal strands 21C to increase the withstand load in the vertical direction of the mesh body 13 (that is, the strength for carrying the crucible). A quartz crucible having heavy weight can be more securely held thereby, thus being able to provide the crucible holding member 100 suitable for a large-sized silicon single crystal pulling-up apparatus.

The strands 15 are each formed by bundling about tens of thousands of carbon fibers 11. As the carbon fibers 11 constituting the strands 21, there can be used pitch-based carbon fibers, PAN-based carbon fibers or the like. The carbon fibers 11 constituting the first strands 21A, the second strands 21B and the longitudinal strands 21C may be the same material or different materials.

The shape of the strands 21 may be a rod form or the like, as well as a ribbon form. Further, if strands subjected to sizing treatment by impregnating them with an epoxy resin or the like are used as the strands 21, appropriate elasticity is obtained to cause easy weaving in an equal cycle even in manually weaving the strands.

A matrix precursor for coating the mesh body 13 may be any, as long as it can form a carbonaceous or graphitic matrix by burning. As the matrix precursor carbonized or graphitized by burning, there can be used pitch obtained from petroleum, coal or the like, as well as a thermosetting resin having a high carbonization yield such as a COPNA resin, a phenol resin, a furan resin or a polyimide resin.

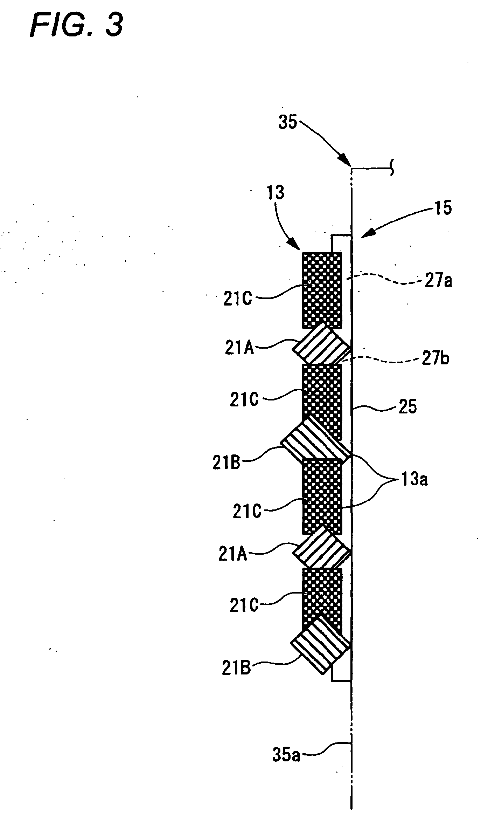

Fig. 3 is an enlarged cross-sectional view schematically showing a part of a plane including an axis line of the crucible holding member 100 shown in Fig. 1.

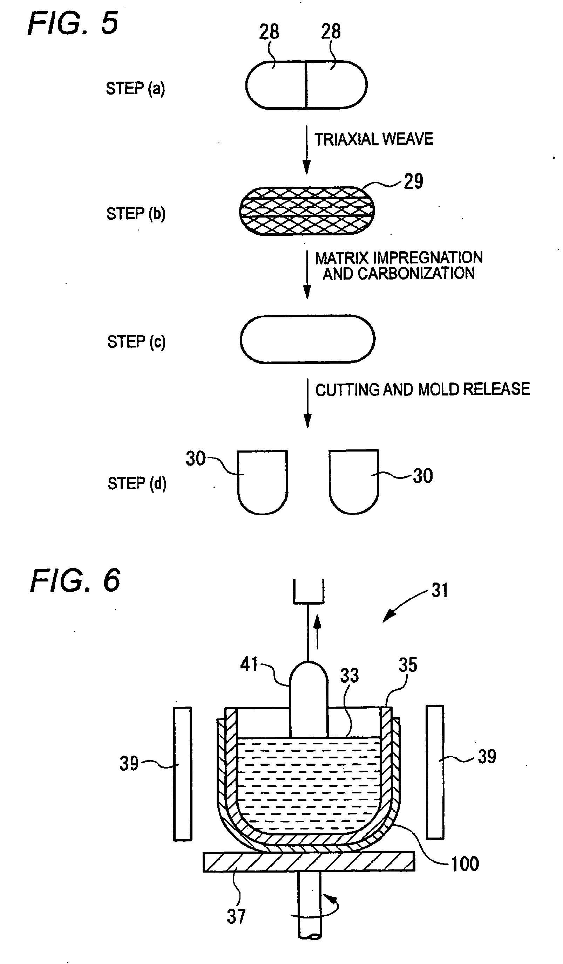

The carbonaceous layer 15 is formed on an inner circumferential surface of the mesh body 13, and has a flat surface 25 to be in close contact with an outer circumferential surface 35a of a quartz crucible 35 shown in Fig. 3 (see Fig. 6). In the crucible holding member 100, this carbonaceous layer 15 formed on the inner circumferential surface 13a of the mesh body 13 fills spaces 27a, 27b and the like formed between the quartz crucible 35 and the mesh body 13, and the flat surface 25 increases the contact area between the quartz crucible 35 and the mesh body 13.

The crucible holding member 100 having the abovementioned configuration comprises the mesh body 13 formed by weaving a plurality of strands 21 arranged diagonally, which comprise the carbon fibers 11, the matrix filled in the interstices between the carbon fibers 11, and the carbonaceous layer 15 formed on the inner circumferential surface 13a of the mesh body 13 to be in contact with the outer circumferential surface 35a of the crucible 35. Accordingly, the shape thereof is stable while securing sufficient strength, even when strong tension is applied in the circumferential direction thereof, and moreover, the spaces 27a and 27b between the crucible holding member and the crucible 35 are filled to increase the contact area, thereby being able to improve thermal conductivity.

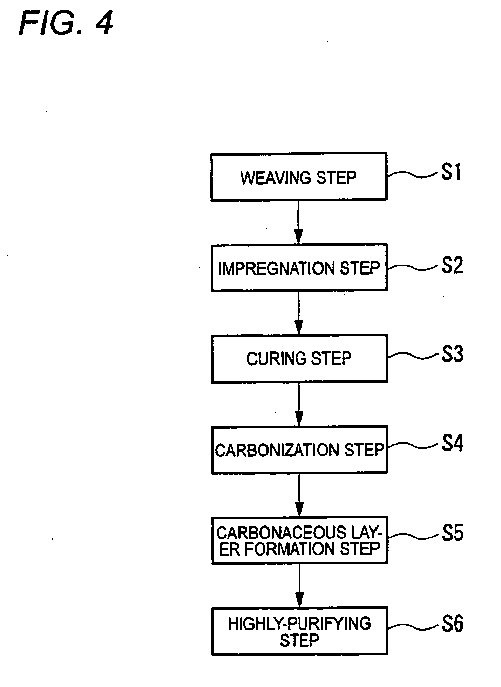

One example of a method for producing the crucible holding member 100 according to this embodiment will be described below with reference to Fig. 4.

Fig. 4 is a flow chart showing a procedure of a production method of a crucible holding member, and Fig. 5 is a schematic view showing a procedure of a production method of a crucible holding member.

The crucible holding member 100 according to this embodiment can be produced mainly by the following six steps: namely, a weaving step S1, an impregnation step S2, a curing step S3, a carbonization step S4, a carbonaceous layer formation step S5 and a highly-purifying step S6.

A) Weaving Step S1

First, a bowl-shaped forming die for forming the triaxial weave mesh body is prepared. Although the material of the forming die is not particularly limited, a forming die made of graphite is preferably used so as not to be carburized in the later carbonization step and the like. If the large-sized mesh body is to be formed, a large-sized forming die may be formed by combining a plurality of graphite material pieces by means of an adhesive. In this case, it is preferred that a COPNA resin is used as the adhesive because the use of the COPNA resin makes it possible to maintain adhesive force even after the carbonization step. Further, when a hollow forming die is used, it is light in weight and easy to handle.

In order to make it easy to perform mold release, it is advantageous to previously wrap a mold releasing film having liquid impermeability and heat resistance around the periphery of the forming die. The material of the film is not particularly limited, as long as it has liquid impermeability and heat resistance at about a curing temperature. Examples thereof include polyethylene terephthalate, a silicone resin, polytetrafluoroethylene, cellophane, polyvinyl chloride, polyvinylidene chloride and the like. If the mold releasing film is wrapped, it does not decompose until curing and decomposes or carbonizes until carbonization, resulting in easy mold release.

Ribbon-like or rod-like strands are each formed by bundling a plurality of carbon fibers, and the strands are woven along an outer periphery of the forming die by a three-dimensional braiding method, thereby being able to form the mesh body. The formation of the mesh body by the three-dimensional braiding method can be performed by a related-art method.

A commercially available automatic loom (for example, TWM-32C, TRI-AX, manufactured by Howa Machinery, Ltd.) can be utilized for weaving the strands. If the mesh body is so large that the automatic loom can not cope with it, the mesh body can be manually formed in the same manner as the formation of braid.

Further, the mesh body may be formed by preparing a triaxial fabric in which the strands are woven in a planar form, and rounding it into a cylindrical form around the periphery of the forming die and bonding it with an adhesive or the like to form the cylindrical body portion 17 of the mesh body, and further, adhering thereto the bottom portion 19 produced by the three-dimensional braiding method.

If the mesh body is prepared using the strands subjected to sizing treatment using an epoxy resin or the like in large amount, and if it becomes difficult to impregnate the mesh body with a resin as a matrix precursor in the subsequent step, defatting treatment may be conducted after the formation of the mesh body in order to remove the sizing material such as the epoxy resin.

The defatting treatment is usually performed by heating at about 150 to 400°C under a nonoxidative atmosphere, It is advantageous that this defatting treatment is performed only when the strands subjected to the sizing treatment using the epoxy resin or the like in large amounts are used.

B) Impregnation Step S2

The mesh body formed in the weaving step S1 is immersed in the uncured matrix precursor to form an original material in which the mesh body is impregnated with the matrix precursor.

The impregnation may be performed either at normal pressure or under increased pressure. If the carbon fibers are thin and wettability with the matrix precursor to be impregnated is poor, the impregnation under increased pressure is effective. Further, if the matrix precursor has sufficient wettablility with the carbon fibers, the matrix precursor can be sufficiently impregnated in the strands only by coating or spraying.

In addition, if vacuuming is performed before the impregnation, voids are not likely to to remain in the strands. Accordingly, the homogeneous original material can be obtained.

C) Curing Step S3

Then, the mesh body (original material) impregnated with the matrix precursor is heated to be cured. Although the curing temperature can be appropriately set depending on the kind of matrix precursor and the like, it is set at a temperature at which gelation reaction associated with the curing severely occurs (roughly about 100°C to 150°C). It may be important to slow down the increase rate of temperature in the vicinity of a predetermined temperature to sufficiently vent a generated gas so as to make it possible to sufficiently diffuse the gas.

D) Carbonization Sep S4

Organic materials contained in the original material obtained in the curing step S3 are carbonized to obtain the mesh body 13 mainly composed of carbon. The treatment temperature in the carbonization step is preferably at least about 600°C (a temperature at which the discharge of the organic gas starts to subside), and more preferably 900°C (a temperature at which contraction in size and gas generation subside) or higher.

Mold release is preferably performed after the carbonization. The carbonization together with the forming die results in less collapse in shape, which does not require afterprocessing for arranging the shape. When the afterprocessing can be omitted, the carbon fibers are not cut, and the mesh body 13 having no splinter can be provided. If the curing is fully performed in the prior step, the mold release may be performed before the carbonization step.

If the carbonization step is performed without releasing the forming die, this step can be performed subsequent to the above-described curing step S3 without lowering the temperature. That is, the curing step S3 can be performed as a part of the carbonization step S4.

E) Carbonaceous Layer Formation Step S5

The carbon precursor comprising the resin material in which the carbon aggregate is mixed is applied onto the inner circumferential surface of the mesh body 13 obtained in the carbonization step S4. Then, the carbon precursor is cured and burned to form the carbonaceous layer 15. In the curing, the temperature is slowly increased to a temperature at which a gelation reaction associated with the curing severely occurs (roughly about 100 to 150°C) at a rate of about 5°C per hour, and the temperature is kept at this state for 1 hour or more to completely perform curing. Then, burning is slowly performed by increase the temperature until at least about 600°C (a temperature at which the discharge of the organic gas starts to subside) to 900°C (a temperature at which contraction in size and gas generation subside) at a rate of 10°C per hour or less. The curing and burning may be performed either as a single step or as separate steps.

F) Highly-Purifying Step S6

The crucible holding member obtained by the method of the carbonaceous layer formation step S5 is subjected to highly-purifying treatment to remove impurities. The highly-purifying treatment can be performed by a related-art method. Specifically, it can be performed by heat treatment in an atmosphere gas such as a halogen gas or a halogenated hydrocarbon at 1,500 to 3,000°C for 1 hour or more.

In the above-described production example, the mesh body is impregnated with the matrix precursor after the preparation of the mesh body. However, the strands are previously impregnated with the matrix precursor, and the mesh body can also be woven using the strands impregnated with the matrix. That is, the crucible holding member can be produced in the order of the impregnation step S2, the weaving step S1, the curing step S3, the carbonization step S4, the carbonaceous layer formation step S5 and the highly-purifying step S6. In any order, it is preferred that the curing step S3 is performed after the impregnation step S2 and the weaving step S1 because the matrix adhered to surfaces of the strands acts as an adhesive among the strands.

Further, in order to improve production efficiency, the mesh body may be produced by a method shown in Fig. 5. In the method shown in Fig. 5, (a) two bowl-shaped forming dies 28 are prepared and joined with each other at opening face sides, and (b) a substantially cylindrical triaxial fabric 29 is produced by triaxial weave around the joined bowl-shaped forming die 31. Furthermore, (c) the impregnation step of the matrix material and the carbonization step thereof are performed, and then, (d) mold release is performed after cutting into two parts at a central portion, thereby being able to produce two mesh bodies 13 at once. If the mesh bodes 13 are produced in such a manner, the mesh bodies 13 can be efficiently produced. In addition, fray at an opening is not likely to occur in the course of from the impregnation of the matrix to the carbonization thereof, because the opening can be narrowed.

According to this method for producing the crucible holding member 100, the strands 21 comprising the carbon fibers 11 are diagonally woven to form the mesh body 13, the matrix is filled in the interstices between the carbon fibers 11 of the mesh body 13, and the carbon precursor comprising the resin material in which the carbon aggregate is mixed is applied onto the inner circumferential surface 13a of the mesh body 13, followed by curing and burning to form the carbonaceous layer. Accordingly, the carbonaceous layer 15 having higher thermal conductivity and filling the spaces 27a and 27b between the crucible holding member and the crucible 35 can be easily formed as a flat coating surface on the inner circumferential surface 13a of the mesh body 13 woven by diagonally aligning the strands 21 comprising the carbon fibers 11. Herein, the flat surface refers to a surface which is more flat compared with that of the woven strands 21 as they are or refers to a surface which is able to surface-contact with a crucible.

Then, as an example of use of the crucible holding member according to this embodiment, an example in which the crucible holding member is applied to a silicon single crystal pulling-up apparatus will be described using Fig. 6.

Fig. 6 is a cross-sectional view showing a silicon single crystal pulling-up apparatus using the crucible holding member according to the embodiment. The silicon single crystal pulling-up apparatus 31 is equipped with a quartz crucible 35 for containing a silicon melt 33 and the closed-end basket-shaped crucible holding member 100 for holding an outer peripheral surface of the quartz crucible 35 in such a state that the quartz crucible is surrounded from the outside. These are placed on a support 37. A heater 39 is arranged around the periphery of the crucible holding member 100, and an ingot 41 is gradually pulled up while heating the silicon melt 33 through the quartz crucible 35 and the crucible holding member 100 by the heater 39, thereby preparing a silicon single crystal.

As described above, even when force to expand in the circumferential direction is applied to the crucible holding member 100, the crucible holding member 100 used herein can follow the expansion. Accordingly, the occurrence of cracks, an outflow of the non-coagulated melt, and the like can be suppressed, thus being able to improve reliability. Further, the carbonaceous layer 15 of the mesh body 13 eliminates the spaces 27a and 27b between the crucible holding member and the crucible 35 to increase the contact area, thereby being able to improve thermal conductivity.

A load caused by the silicon melt 33 is little applied to an upper side of the crucible holding member 100 at which coagulation of the silicon melt 33 first occurs, when the silicon single crystal pulling-up apparatus 31 is cooled. When the silicon melt coagulates in the initiation of pulling-up, the upper side directly receives volume expansion of the silicon melt 33, so that it is preferred that the angle of inclination θ is decreased in order to decrease the rigidity. On the other hand, a load caused by the silicon melt 33 is largely applied to a lower portion side. However, even when the silicon melt coagulates in the initiation of pulling-up, the lower portion side is not likely to directly receive the volume expansion of the silicon melt 33 because the bottom portion of the quartz crucible is rounded. It is therefore preferred that the angle of inclination θ is increased so as to increase the rigidity.

In the case where the angle of inclination θ is decreased, even when the expansion of the silicon melt 33 occurs to extend in a lateral direction (in the circumferential direction), it is possible to easily follow the extension in the lateral direction because the degree of shrinkage in a longitudinal direction (in a height direction) to the extension in the lateral direction is small. However, in the case where the angle of inclination θ is increased, even when the expansion of the silicon melt 33 occurs to extend in the lateral direction, it is hard to easily follow the extension in the lateral direction, resulting in the application of strong force to the respective strands, because the degree of shrinkage in the longitudinal direction to the extension in the lateral direction increases. Accordingly, the first or second strands are broken, or the longitudinal strands become easy to buckle.

If the silicon single crystal pulling-up apparatus 31 is a large size which can produce a large-diameter ingot, it is preferred that the crucible holding member 100 has low thermal conductivity in an up and down direction so as to give such a temperature gradient that the temperature of an upper potion becomes high and that of a lower portion becomes low in the silicon melt 33. If the silicon single crystal pulling-up apparatus 31 is the large size, the time taken for pulling up becomes relatively long, resulting in containing the silicon melt 33 in the quartz crucible 35 for a long period of time. If the silicon melt 33 is placed in the quartz crucible 35 for a long period of time, the silicon melt 33 is liable to be contaminated with oxygen from the quartz crucible 35. However, the contamination with oxygen can be prevented by inhibiting convection of the silicon melt 33 as much as possible.

The carbon fibers which form the strands having low thermal conductivity include, for example, general carbonaceous carbon fibers (to graphitic carbon fibers) and the like.

In addition, it is advantageous to provide a carbonaceous or graphitic sheet such as an expanded graphite sheet or a carbon fiber papermade sheet between the crucible holding member 100 and the quartz crucible 35. If such a carbonaceous or graphitic sheet is provided, the quartz crucible 35 and the crucible holding member 100 do not directly contact with each other, so that the deterioration of the crucible holding member 100 caused by a reaction with the quartz crucible 35 is not likely to occur. Accordingly, the crucible holding member can be repeatedly used by exchanging only the carbonaceous or graphitic sheet.

In the above-described example of use, there is described the example in which the crucible holding member is applied to the quartz crucible holding member for the silicon single crystal pulling-up apparatus. However, the use of the crucible holding member according to the invention is not limited thereto, and it can be applied to any use, as long as it is, for example, a member for holding a container for containing a melt of metal, glass, silicon or the like. In particular, the container holding member may be applied to a member for holding a container different therefrom in the thermal expansion coefficient.

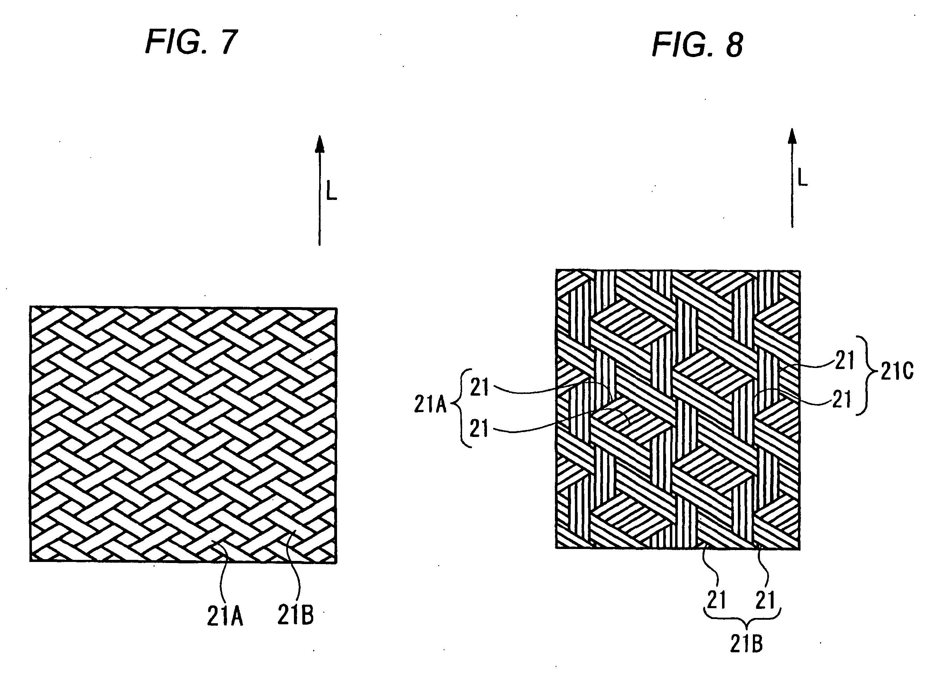

Fig. 7 is an enlarged front view showing a part of a modified example of a weave configuration having no longitudinal strands, and Fig. 8 is an enlarged front view showing a part of a modified example of a weave configuration having a plurality of diagonal strands.

In the above-described embodiment, the mesh body 13 formed by the triaxial weave is shown. However, the mesh body according to the invention is not limited to a mesh body obtained by triaxial weave, and may have a configuration having only strands 21A and 21B aligned diagonally to an axis line L, as shown in Fig. 7. That is, the mesh body has no strand in the circumferential direction in a plane perpendicular to the axis line L (in the lateral direction in Fig. 7). According to this configuration, even when such force as to expand in the circumferential direction acts, stress is not concentrated to some of the strands because no strand in the circumferential direction is present. Therefore, breakage of the strands is not likely to occur. Further, as shown in Fig. 8, it may have a configuration in which two or more strands 21 and 21 are aligned diagonally.

Furthermore, in the above-described embodiments, the mesh body comprises a substantially cylindrical body portion and the bowl-shaped bottom portion to have a substantially basket shape with a closed-end, However, the mesh body comprises only the cylindrical body portion, and a bottom portion may be formed by another member.

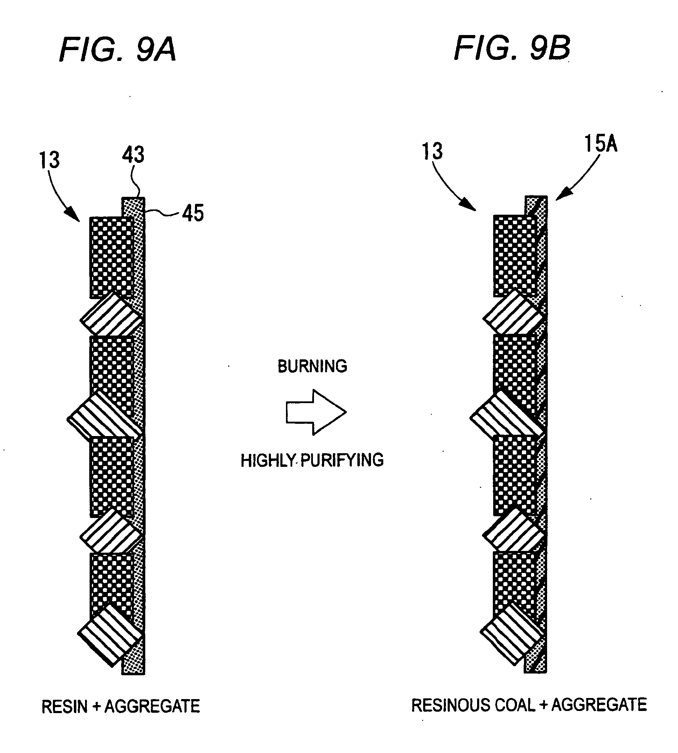

Fig. 9 is a schematic view showing one example of obtaining a carbonaceous layer by kneading (mixing) an aggregate with a resin material as a carbon precursor.

As shown in Fig. 9, a carbonaceous layer 15A is obtained by applying a mixture of a carbon precursor 43 and an aggregate 45 onto the mesh body 13, and performing highly-purifying treatment. The carbon precursor 43 may be any, as long as it can be carbonized by burning under an inert atmosphere. For example, it may be any such as pitch obtained from petroleum or coal, a phenol resin, polyvinyl chloride or polyvinylidene chloride, as long as it can be carbonized by burning. The aggregate 45 may be any, as long as it is carbonaceous (carbon aggregate). For example, the aggregate 45 may includes natural graphite powder, artificial graphite powder, coke and carbon short fibers. A paste in which the carbon aggregate 45 is kneaded with the resin material as the carbon precursor 43 is applied onto the inner circumferential surface 13a, and burned. Accordingly, the carbonaceous aggregate 45 acts as a reinforcing material in which the carbonaceous aggregate 45 is integrally embedded in resinous coal to increase not only the strength of the carbonaceous layer 15B, but also the strength of the whole crucible holding member.

## Claims

1. A crucible holding member (100) for holding a crucible (35) for containing a melt, the crucible holding member comprising:
a mesh body (13) which has a cylinder shape or a basket shape with a closed end, the mesh body being formed by weaving a plurality of strands (21) to be aligned diagonally with respect to an axis line (L) of the mesh body, each of the strands comprising a plurality of carbon fibers (11);
a matrix filled in interstices between the plurality of carbon fibers; and
a carbonaceous layer (15) formed on an inner circumferential surface of the mesh body and having a flat surface (25) to contact with an outer circumferential surface (35a) of the crucible (35);
wherein the mesh body comprises
a plurality of first strands aligned in a first direction inclined at a first angle +θ with respect to the axis line of the mesh body, and
a plurality of second strands aligned in a second direction inclined at a second angle -θ same as the first angle with respect to the axis line of the mesh body,
**characterised in that**
the first angle and the second angle vary according to a position of the mesh body.

2. The crucible holding member according to claim 1, the carbonaceous layer comprising a carbonized resin and any one of natural graphite powder, artificial graphite powder, coke and carbon short fibers.

3. The crucible holding member according to any one of claims 1 or 2, wherein the mesh body comprises a plurality of longitudinal strands aligned substantially along the axis line of the mesh body.

4. A method for producing a crucible holding member (100), the method comprising:
weaving a plurality of strands (21) to be aligned diagonally with respect to an axis line to form a mesh body (13) having a cylinder shape or a basket shape with a closed end, each of the strands comprising a plurality of carbon fibers;
filling a matrix precursor in interstices between the plurality of carbon fibers;
applying onto an inner circumferential surface of the mesh body a carbon precursor comprising a resin material in which a carbon aggregate is mixed; and
curing and burning the carbon precursor to form a carbonaceous layer (15);
wherein the weaving comprises:
providing a plurality of first strands (21A) aligned in a first direction inclined at a first angle +θ with respect to the axis line (L) of the mesh body; and
providing a plurality of second strands (21B) aligned in a second direction inclined at second angle -θ with respect to the axis line (L) of the mesh body,
**characterised in that**
the first angle and the second angle vary according to a position of the mesh body.

5. The method according to claim 4,
wherein the weaving comprises providing a plurality of longitudinal strands (21C) aligned substantially along the axis line of the mesh body.

## Patentansprüche

1. Tiegelhalteelement (100) zum Halten eines Tiegels (35) zum Aufbewahren einer Schmelze, das Tiegelhalteelement mit:
einem Gewebekörper (13), der eine Zylinderform oder eine Korbform mit einem geschlossenen Ende aufweist, wobei der Gewebekörper durch Verweben mehrerer Stränge (21) ausgebildet ist, die diagonal in Bezug auf eine Achsenlinie (L) des Gewebekörpers auszurichten sind, wobei jeder der Stränge mehrere Kohlefasern (11) aufweist;
einer Matrix, die in Zwischenräume zwischen den mehreren Kohlefasern eingefüllt ist; und
einer kohlhaltigen Schicht (15), die auf einer inneren Umfangsoberfläche des Gewebekörpers ausgebildet ist und die eine flache Oberfläche (25) aufweist, um mit einer äußeren Umfangsoberfläche (35a) des Tiegels (35) in Kontakt zu sein;
wobei der Gewebekörper aufweist
mehrere erste Stränge, die in einer ersten Richtung um einen ersten Winkel +θ in Bezug auf die Achsenlinie des Gewebekörpers geneigt ausgerichtet sind, und
mehrere zweite Stränge, die in einer zweiten Richtung ausgerichtet sind, die um einen zweiten Winkel -θ, welcher der gleiche ist wie der erste Winkel, in Bezug auf die Achsenlinie des Gewebekörpers geneigt sind,
**dadurch gekennzeichnet, dass**
sich der erste Winkel und der zweite Winkel entsprechend einer Position des Gewebekörpers verändern.

2. Tiegelhalteelement nach Anspruch 1, wobei die kohlehaltige Schicht ein karbonisiertes Harz und natürliches Graphitpulver, künstliches Graphitpulver, Koks und/oder kurze Kohlefasern aufweist.

3. Tiegelhalteelement nach Anspruch 1 oder 2, wobei der Gewebekörper mehrere Längsstränge aufweist, die im Wesentlichen entlang der Achsenlinie des Gewebekörpers ausgerichtet sind.

4. Verfahren zum Herstellen eines Tiegelhalteelements (100), wobei das Verfahren aufweist:
Weben mehrerer Stränge (21), die in Bezug auf eine Achsenlinie diagonal auszurichten sind, um einen Gewebekörper (13), der eine Zylinderform oder eine Korbform mit einem geschlossenen Ende aufweist, auszubilden, wobei jeder der Stränge mehrere Kohlefasern aufweist;
Einfüllen eines Matrixvorprodukts in Zwischenräume zwischen den mehreren Kohlefasern;
Aufbringen eines Kohlevorprodukts, welches ein Harzmaterial aufweist, in das ein Kohleaggregat eingemischt ist, auf eine innere Umfangsoberfläche des Gewebekörpers; und
Aushärten und Brennen des Kohlevorprodukts, um eine kohlehaltige Schicht (15) auszubilden;
wobei das Weben aufweist:
Bereitstellen mehrerer erster Stränge (21A), die in einer ersten Richtung ausgerichtet sind, die um einen ersten Winkel +θ in Bezug auf die Achsenlinie (L) des Gewebekörpers geneigt ist; und
Bereitstellen mehrerer zweiter Stränge (21B), die in einer zweiten Richtung ausgerichtet sind, die um einen zweiten Winkel -θ in Bezug auf die Achsenlinie (L) des Wabenkörpers geneigt ist,
**dadurch gekennzeichnet, dass**
der erste Winkel und der zweite Winkel gemäß einer Position des Gewebekörpers variieren.

5. Verfahren nach Anspruch 4,
bei dem das Weben aufweist, dass mehrere Längsstränge (21C) bereitgestellt werden, die im Wesentlichen entlang der Achsenlinie des Gewebekörpers ausgerichtet sind.

## Revendications

1. Élément de maintien de creuset (100) pour maintenir un creuset (35) pour contenir une coulée, l'élément de maintien de creuset comprenant :
un corps à mailles (13) qui a une forme de cylindre ou une forme de panier avec une extrémité fermée, le corps à mailles étant formé en tissant une pluralité de torons (21) devant être alignés en diagonale par rapport à une ligne d'axe (L) du corps à mailles, chacun des torons comprenant une pluralité de fibres de carbone (11) ;
une matière composite remplie dans des interstices entre la pluralité de fibres de carbone ; et
une couche carbonée (15) formée sur une surface circonférentielle intérieure du corps à mailles et ayant une surface plate (25) pour entrer en contact avec une surface circonférentielle extérieure (35a) du creuset (35) ;
dans lequel le corps à mailles comprend
une pluralité de premiers torons alignés dans une première direction inclinée à un premier angle +θ par rapport à la ligne d'axe du corps à mailles, et
une pluralité de seconds torons alignés dans une seconde direction inclinée à un second angle -θ, le même que le premier angle par rapport à la ligne d'axe du corps à mailles,
**caractérisé en ce que**
le premier angle et le second angle varient selon une position du corps à mailles.

2. Élément de maintien de creuset selon la revendication 1, la couche carbonée comprenant une résine carbonisée et n'importe lequel de poudre de graphite naturel, de poudre de graphite artificiel, de coke et de fibres courtes de carbone.

3. Élément de maintien de creuset selon l'une quelconque des revendications 1 ou 2, dans lequel le corps à mailles comprend une pluralité de torons longitudinaux alignés sensiblement le long de la ligne d'axe du corps à mailles.

4. Procédé pour produire un élément de maintien de creuset (100), le procédé comprenant :
le tissage d'une pluralité de torons (21) à aligner en diagonale par rapport à une ligne d'axe pour former un corps à mailles (13) ayant une forme de cylindre ou une forme de panier avec une extrémité fermée, chacun des torons comprenant une pluralité de fibres de carbone ;
le remplissage d'un précurseur de matrice dans des interstices entre la pluralité de fibres de carbone ;
l'application sur une surface circonférentielle intérieure du corps à mailles d'un précurseur de carbone comprenant une matière de résine dans laquelle un agrégat de carbone est mélangé ; et
la cuisson et la combustion du précurseur de carbone pour former une couche carbonée (15) ;
dans lequel le tissage comprend :
la fourniture d'une pluralité de premiers torons (21A) alignés dans une première direction inclinée à un premier angle +θ par rapport à la ligne d'axe (L) du corps à mailles ; et
la fourniture d'une pluralité de seconds torons (21B) alignés dans une seconde direction inclinée à un second angle -θ par rapport à la ligne d'axe (L) du corps à mailles,
**caractérisé en ce que**
le premier angle et le second angle varient selon une position du corps à mailles.

5. Procédé selon la revendication 4,
dans lequel le tissage comprend la fourniture d'une pluralité de torons longitudinaux (21C) alignés sensiblement le long de la ligne d'axe du corps à mailles.
